(19) **Europäisches Patentamt**

**European Patent Office**

**Office européen des brevets**

(11) **EP 0 962 545 B1**

(12) **FASCICULE DE BREVET EUROPEEN**

(45) Date de publication et mention
de la délivrance du brevet:
**31.07.2002   Bulletin 2002/31**

(51) Int Cl.7: **C23C 14/08**, C23C 28/04

(21) Numéro de dépôt: **99401332.4**

(22) Date de dépôt: **03.06.1999**

(54) **Revêtement céramique à faible conductivité thermique**

Beschichtung auf Keramikbasis mit niedriger Wärmeleitfähigkeit

Ceramic coating having a low thermal conductivity

(84) Etats contractants désignés:
**DE FR GB NL**

(30) Priorité:  **04.06.1998  FR 9806986**

(43) Date de publication de la demande:
**08.12.1999   Bulletin 1999/49**

(73) Titulaires:
  • **SNECMA MOTEURS**
    **75015 Paris (FR)**
  • **Snecma Services**
    **75015 Paris (FR)**

(72) Inventeurs:
  • **Jaslier, Yann Philippe**
    **77000 Melun (FR)**
  • **Malie, André Hubert Louis**
    **86100 Targe (FR)**
  • **Huchin, Jean-Pierre Julien Charles**
    **86100 Chatellerault (FR)**

  • **Alperine, Serge Alexandre**
    **75004 Paris (FR)**
  • **Portal, Romain**
    **91000 Evry (FR)**

(56) Documents cités:
  **GB-A- 2 252 567**

  • **PRATER J T ET AL: "CERAMIC THERMAL
    BARRIER COATINGS WITH IMPROVED
    CORROSION RESISTANCE" SURFACE AND
    COATINGS TECHNOLOGY, vol. 32, 1 janvier
    1987 (1987-01-01), pages 389-397, XP000564372**
  • **PATENT ABSTRACTS OF JAPAN vol. 095, no.
    011, 26 décembre 1995 (1995-12-26) & JP 07
    207441 A (NISSIN ELECTRIC CO LTD), 8 août
    1995 (1995-08-08)**
  • **"DEPOSIT AND ETCH TECHNIQUE FOR MAKING
    SMOOTH, LOW RESISTIVITY TUNGSTEN
    FILMS" RESEARCH DISCLOSURE, no. 305, 1
    septembre 1989 (1989-09-01), page 633
    XP000070496**

# Description

L'invention concerne un revêtement céramique à faible conductivité thermique et de type barrière thermique, un procédé de dépôt d'un tel revêtement céramique, et une pièce métallique protégée par ce revêtement céramique. L'invention s'applique notamment à la protection des parties chaudes de turbomachines en superalliage, telles que des aubes de turbines ou des distributeurs.

Les constructeurs de moteurs à turbine, terrestres ou aéronautiques, sont confrontés à des impératifs d'augmentation de rendement et de réduction de leur consommation spécifique. Une des façons de répondre à ces impératifs consiste à augmenter la température de gaz brûlés en entrée de turbine. Cette approche est cependant limitée par la capacité des pièces de la turbine, tels que les distributeurs ou les aubes mobiles des étages haute pression, de pouvoir résister aux hautes températures. Des matériaux métalliques réfractaires, appelés superalliages, ont été développés pour constituer ces composants. Ces superalliages à base de nickel, de cobalt ou de fer, confèrent au composant la résistance mécanique aux hautes températures (résistance au fluage). La température limite d'utilisation de ces superalliages est de 1100°C ce qui est bien en deçà de la température des gaz brûlés en entrée de turbine qui est typiquement de 1600°C. Les aubes et les distributeurs sont refroidis par convection en introduisant, dans leurs cavités internes, de l'air à 600°C prélevé sur les étages du compresseur. Une partie de cet air de refroidissement qui circule dans les canaux intérieurs des pièces est évacuée par les trous de ventilation percés dans la paroi pour former un film d'air froid entre la surface de la pièce et les gaz chauds. Pour obtenir des gains significatifs de température en entrée de turbine, il est connu de déposer un revêtement de barrière thermique sur les pièces.

La technologie des barrières thermiques consiste à revêtir les pièces par une fine couche de céramique isolante d'une épaisseur pouvant varier de quelques dizaines de micromètres à quelques millimètres. La couche de céramique est typiquement constituée de zircone stabilisée avec de l'yttrine qui présente les avantages d'une faible conductivité thermique et d'une bonne stabilité chimique nécessaire dans les conditions sévères du fonctionnement de la turbine. Une sous-couche de liaison en alliage métallique aluminoformeur peut être intercalée entre le superalliage et la couche céramique. Sa fonction est de promouvoir l'adhérence de la couche céramique en protégeant le substrat de l'oxydation.

L'application d'un revêtement céramique sur une pièce métallique pose le problème de la dilatation différentielle métal/céramique pendant les cyclages thermiques. Même si les céramiques à base de zircone possèdent un coefficient de dilatation thermique relativement élevé, celui-ci demeure notablement inférieur à celui des métaux. La microstructure du revêtement doit donc être contrôlée de manière à pouvoir subir, sans s'écailler, les déformations thermiques imposées par le substrat métallique.

La projection thermique et le dépôt physique en phase vapeur sous-faisceau d'électrons, désigné par l'acronyme anglais EB-PVD (electron beam physical vapour deposition) sont les deux procédés utilisés dans l'industrie pour déposer les barrières thermiques. Pour l'application sur la pale des aubes et des distributeurs, la méthode de dépôt EB-PVD est préférée à la projection thermique principalement en raison d'un meilleur état de surface du revêtement et du contrôle de l'obstruction des trous de ventilation des pièces. De plus, ce procédé permet de conférer à la couche une microstructure qui consiste en des microcolonnes, ou colonnettes, perpendiculaires à la surface de la pièce. Cette microstructure permet au revêtement de s'accommoder des déformations d'origine thermique ou mécanique dans le plan du substrat. De ce fait, les barrières thermiques EB-PVD possèdent une durabilité en fatigue thermomécanique réputée meilleure que celle des couches céramique déposées par projection plasma.

Dans les procédés de dépôt en phase vapeur, le revêtement résulte de la condensation de vapeur sur la pièce à recouvrir. Les procédés en phase vapeur sont de deux catégories. On distingue les procédés physiques (PVD) des procédés chimiques en phase vapeur (CVD). Dans les procédés physiques en phase vapeur, la vapeur recouvrante résulte de la vaporisation d'un matériau solide aussi appelé cible. La vaporisation peut être obtenue par évaporation sous l'effet d'une source de chaleur ou par la pulvérisation cathodique, procédé dans lequel la matière est atomisée à partir d'un bombardement ionique sur la cible. Dans les procédés chimiques en phase vapeur, la vapeur recouvrante est le fruit d'une réaction chimique entre des espèces gazeuses qui a lieu soit en phase vapeur, soit à l'interface revêtement/gaz. Les procédés de dépôt en phase vapeur sont réalisés sous atmosphère contrôlée de manière à ne pas contaminer ou polluer les dépôts par réaction avec des espèces gazeuses indésirables. Pour cela, l'enceinte de dépôt est préalablement pompée jusqu'à un vide secondaire (compris entre $10^{-6}$ Torr et $10^{-4}$ Torr) et étuvée. Un gaz de travail inerte ou réactif peut être introduit de façon contrôlée pendant le dépôt.

L'évaporation de matériaux aussi réfractaires que les céramiques requiert un moyen de chauffage intense. Pour cela on utilise le chauffage par faisceaux d'électrons. Le matériau céramique à évaporer se présente sous forme de barreaux frittés dont la surface est balayée par un faisceau d'électrons focalisé. Une partie de l'énergie cinétique du faisceau est convertie sous forme de chaleur à la surface du barreau. Dans le procédé EB-PVD en particulier, la pression de travail est réduite de manière à faciliter l'évaporation des barreaux et le transfert de vapeur recouvrante de la cible au substrat. De plus, les canons à électrons nécessitent des pres-

sions inférieures à $10^{-4}$ Torr pour pouvoir fonctionner (problèmes d'arcage) ce qui peut nécessiter un pompage des canons à électrons séparé de celui de la chambre. Pendant le dépôt de barrières thermiques par EB-PVD, les pièces sont portées à une température élevée avoisinant 1000°C assuré par le chauffage radiatif des barreaux. On estime la température de surface des barreaux à 3500°C. A cette température, une partie des molécules de zircone émanant de la surface du barreau se dissocie selon la réaction :

$$ZrO_2 \rightarrow ZrO + \tfrac{1}{2}\, O_2$$

Une partie de l'oxygène ainsi dissocié des molécules d'oxydes de zirconium est perdu par pompage de l'enceinte ce qui a pour conséquence de rendre les dépôts de zircone sous-stoechiométrique (déficience en oxygène). Cet effet peut être corrigé par introduction dans l'enceinte, pendant le dépôt, d'un gaz riche en oxygène (typiquement un mélange d'argon et d'oxygène) à une pression de quelques miliTorrs. Cet effet peut aussi être corrigé ex situ lorsqu'on n'introduit pas de gaz réactif dans l'enceinte pendant le dépôt. La stoechiométrie du revêtement est alors restaurée en faisant subir aux pièces revêtues un simple recuit à l'air à une température de 700°C pendant 1 heure. L'introduction d'oxygène à l'intérieur de l'enceinte EB-PVD permet également de pré-oxyder les pièces in situ avant le dépôt de céramique. Le film d'alumine ainsi formé à la surface de la sous-couche de liaison assure une bonne adhérence de la couche céramique. Dans le procédé EB-PVD industriel, seules les surfaces de la pièce disposées en regard de la source d'évaporation sont recouvertes. Pour recouvrir une pièce de géométrie complexe telle qu'une aube mobile ou un distributeur, il est nécessaire de mettre en rotation la pièce dans le flux de vapeur recouvrante.

Si les couches céramique EB-PVD présentent des avantages indéniables pour une utilisation sur les pales de turbine, elles possèdent l'inconvénient majeur d'une conductivité thermique (typiquement de 1,4 à 1,9 W/mK) qui est deux fois plus élevée que celle des barrières thermiques projetées plasma (de 0,5 à 0,9 W/mK). Cette différence de conductivité thermique est associée à la morphologie des dépôts. Les colonnettes de céramique disposées perpendiculairement à la surface de la pièce dans les dépôts EB-PVD offrent peu de résistance au transfert thermique par conduction et par rayonnement. En revanche, les dépôts réalisés par projection plasma contiennent un réseau de microfissures plus ou moins parallèles au plan du dépôt, il s'agit en général de joints imparfaits entre les gouttelettes de céramique écrasées lors de la projection. Ces microfissures s'avèrent bien plus efficaces pour inhiber la conduction de la chaleur à travers le dépôt. Le pouvoir isolant d'une couche céramique est proportionnel à sa conductivité et à son épaisseur. Pour un même pouvoir isolant, la diminution de moitié de la conductivité thermique de la couche céramique permettrait de déposer une épaisseur de dépôt approximativement deux fois moindre, ce qui constituerait un avantage considérable pour une application sur les aubes mobiles qui sont soumises à la force centrifuge.

Le brevet WO 96/11288, décrit un revêtement de barrière thermique de type composite stratifié qui consiste en un empilement de couches nanométriques (d'épaisseur comprise entre 0,001 et 1 micromètre) de nature différente (typiquement zircone/alumine). L'abaissement de la conductivité thermique obtenue avec une telle structure est attribué à la dispersion des phonons aux interfaces entre les couches, les phonons étant pour une large part responsables du transfert conductif dans les diélectriques. Ce document décrit des revêtements multicouches d'épaisseur fine de l'ordre de 4 à 5 micromètres qui possèdent une conductivité thermique réduite de moitié par rapport à celle que l'on peut calculer à partir d'une loi des mélanges. Dans ce revêtement c'est la création d'interfaces entre deux couches de nature différente qui produit la réduction de conductivité thermique. Une telle structure sandwich composée de couches nanométriques présente un problème d'instabilité thermique. Pendant des séjours longs à des températures élevées (supérieures à 1100°C) caractéristiques des conditions de fonctionnement, les fines couches risquent d'interdiffuser et de mener à l'homogénéisation du matériau, donc à la disparition des interfaces qui étaient responsables de la diminution de la conductivité thermique.

Le brevet W0 93/18199 et le brevet européen EP 0705912 décrivent une barrière thermique dont le revêtement céramique consiste en une pluralité de couches de structure différente. Les couches adjacentes ont une structure différente afin de pouvoir créer un interface entre chaque couche. La morphologie colonnaire du dépôt dans son épaisseur est conservée, ce qui est considéré comme une propriété fondamentale pour ne pas souffrir d'abattements en termes de résistance au cyclage thermique. Dans ce procédé, la structure multicouche est obtenue par l'application d'un bombardement ionique intermittent de la surface de la couche en conjonction avec la condensation de la vapeur. Le bombardement ionique est obtenu en polarisant la pièce avec une haute tension négative ce qui a pour effet de placer la pièce en cathode d'une décharge gazeuse. L'effet du bombardement ionique intermittent sur la morphologie de la couche céramique ainsi obtenue conduit à la création de couches de céramique plus ou moins denses. Cependant un tel revêtement n'est pas apte à conserver une conductivité thermique réduite puisqu'il est connu que le vieillissement thermique entraîne la densification des colonnes et réduit l'écart de densité entre les différentes couches. En outre l'association d'une haute tension électrique avec les hautes températures (1000°C) requises pour le dépôt EB-PVD constitue une complexité considérable de mise en oeuvre à l'échelle d'une installation industrielle.

De manière générale les barrières thermiques qui comportent une structure de micro-composites laminés, plus communément appelés multicouches, c'est-à-dire des microstructures basées sur la présence d'une interface pour augmenter la résistance au flux thermique, ne sont pas viables pour une application aux hautes températures pour des raisons d'instabilité thermique de ces interfaces en fonctionnement. En raison d'un phénomène de diffusion aux hautes températures, une interface entre deux matériaux de composition ou de structure différente se dégrade en une zone graduée. Cela implique la disparition de l'interface et de sa résistance thermique associée.

Le but de l'invention est de réaliser un revêtement céramique de type barrière thermique déposé par un procédé de dépôt en phase vapeur, qui présente une résistance thermique équivalente à celle des revêtements céramiques classiques et une conductivité thermique au moins deux fois plus faible que celle obtenue avec les procédés de dépôt EB-PVD classiques, la conductivité thermique ne se dégradant pas avec le vieillissement en fonctionnement, voire se bonifiant.

Pour cela, la morphologie du revêtement céramique est différente des structures colonnaires classiques qui comportent des microcolonnes continues dans l'épaisseur du dépôt ; la morphologie du revêtement céramique comporte un motif de croissance colonnaire interrompu et répété de façon maîtrisée dans son épaisseur, appelée morphologie à germination répétée. Le revêtement comporte une microstructure fibreuse qui est plus fine par rapport aux dépôts colonnaires classiques.

Un autre but de l'invention est d'élaborer un procédé de dépôt en phase vapeur permettant d'obtenir ledit revêtement céramique.

Selon l'invention, le revêtement céramique de type barrière thermique déposé sur un substrat est caractérisé en ce qu'il comporte en épaisseur, un motif de croissance colonnaire interrompu et répété plusieurs fois par regermination successive du dépôt de céramique de manière à obtenir des couches adjacentes de même composition et de même structure.

L'invention concerne également un procédé de dépôt en phase vapeur d'un revêtement céramique de type barrière thermique, dans lequel une germination et une croissance du revêtement sont réalisées dans une enceinte de dépôt par condensation de vapeur sur un substrat à recouvrir, caractérisé en ce qu'il consiste à introduire dans l'enceinte de dépôt, pendant le dépôt et de façon intermittente, un gaz polluant interagissant avec la surface de la céramique en cours de dépôt et/ ou avec les espèces chimiques présentes en phase vapeur dans le volume de l'enceinte de dépôt de façon à provoquer des regerminations successives de la céramique en cours de condensation. On entend par gaz polluant, un gaz qui provoque une rupture du motif de croissance cristallographique du revêtement en cours de dépôt sans nuire à l'intégrité mécanique de la pièce.

L'invention concerne aussi une pièce métallique en superalliage ayant au moins une partie de sa surface revêtue par un revêtement céramique selon l'invention.

D'autres particularités ou avantages de l'invention apparaîtront clairement dans la suite de la description donnée à titre d'exemple non limitatif et faite en regard des figures annexées qui représentent :

- la figure 1, un schéma montrant la morphologie, en épaisseur, d'un revêtement céramique colonnaire classique déposé en phase vapeur par un procédé EB-PVD classique ;

- la figure 2, un exemple de variation locale de la conductivité thermique d'un revêtement céramique colonnaire classique en fonction de son épaisseur ;

- la figure 3, un schéma montrant la morphologie, en épaisseur, d'un revêtement céramique à germination répétée, selon l'invention ;

- les figures 4a et 4b, deux photos montrant la morphologie fibreuse du revêtement céramique à germination répétée avant (4a) et après (4b) vieillissement thermique, selon l'invention ;

- les figures 5a et 5b, l'évolution de la conductivité thermique d'un revêtement céramique classique, respectivement à germination répétée, en fonction de l'épaisseur du revêtement ;

- la figure 6, un schéma montrant un premier exemple de cycle d'introduction du gaz polluant, selon l'invention ;

- la figure 7 un schéma montrant un deuxième exemple de cycle d'introduction du gaz polluant, selon l'invention.

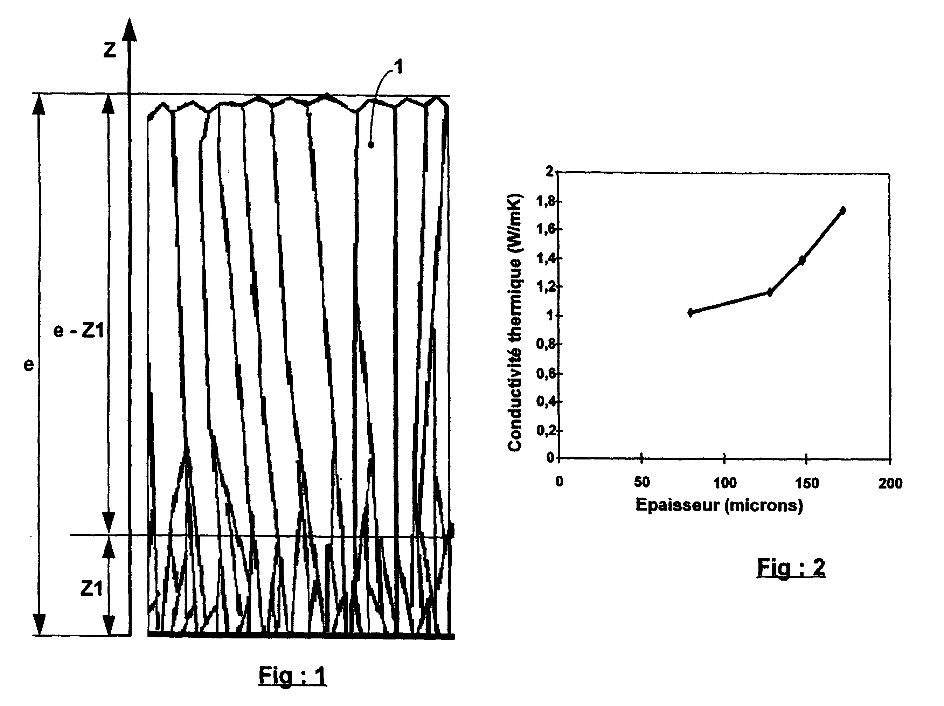

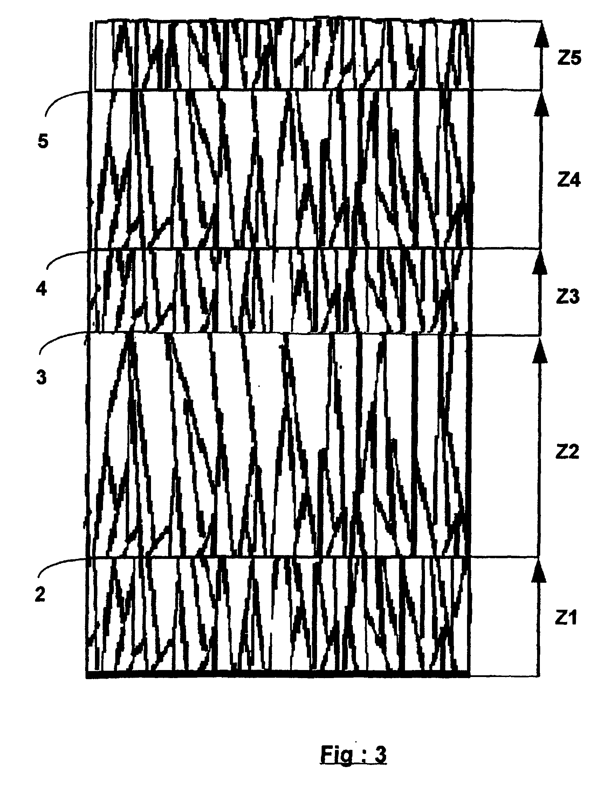

L'invention prend ses fondements sur le constat qu'un revêtement de céramique déposé en phase vapeur, tel que représenté sur la figure 1, possède une morphologie qui est évolutive dans son épaisseur. Ce gradient de morphologie se manifeste en particulier par une densité de colonnettes 1 qui décroît en fonction de l'épaisseur du dépôt. Les colonnettes de céramique sont particulièrement fines à l'interface avec le substrat et peuvent être assimilées à des fibres. Ces colonnettes ont tendances à s'évaser dans la région externe de la couche céramique. Une des conséquences de l'évolution de la morphologie du revêtement céramique avec l'épaisseur se traduit par le fait que la conductivité thermique d'un tel revêtement augmente avec son épaisseur (Figure 2). La région externe du revêtement céramique possède une conductivité thermique qui est plus élevée que la région du revêtement qui est adjacente au substrat. Cet effet a été remarqué pour des matériaux très conducteurs de la chaleur tels que le diamant déposé par CVD et pour des matériaux moins conducteurs tels que la zircone yttriée. La morphologie d'une couche de structure colonnaire d'épaisseur **e** déposée en phase vapeur peut être modélisée comme étant constituée d'une couche adjacente au substrat, d'épaisseur $Z_1$, caractérisée en ce que le diamètre moyen des colonnes est faible et une couche externe du revêtement d'épaisseur, $e-Z_1$, caractérisée en ce que le diamètre moyen des colonnes est élevé. L'épaisseur de la couche adjacente au substrat dont le diamètre des colonnes est faible correspond aux étapes de germination et de croissance compétitive des colonnettes du dépôt. La zone externe du revêtement correspond aux colonnettes qui ont passé l'étape sélective de croissance compétitive. Pour des conditions de dépôt données, l'épaisseur de la zone de croissance compétitive est fixée et n'excède pas en général la dizaine de micromètres alors que la zone de croissance externe n'a pas de limite théorique et augmente avec le temps de dépôt.

La figure 3 représente un revêtement céramique, selon l'invention.

Le revêtement épais comporte une structure qui reproduit plusieurs fois dans son épaisseur la zone de germination et de croissance compétitive des dépôts en phase vapeur. Or la germination de couches déposées en phase vapeur par des procédés classiques n'intervient naturellement qu'une fois au niveau de l'interface avec le substrat. La présente invention consiste à réaliser un revêtement à germination répétée. La morphologie du revêtement d'après la présente invention possède un motif de croissance colonnaire qui consiste en la répétition dans l'épaisseur du dépôt, de la structure de la couche adjacente avec le substrat. Pour cela il faut provoquer la regermination de la couche céramique. Le motif de croissance colonnaire est interrompu et répété plusieurs fois dans son épaisseur par regermination successive du dépôt de la couche céramique. Le revêtement de céramique comporte des interfaces 2, 3, 4 et 5 parallèles au plan de dépôt, ces interfaces séparant des couches de céramique d'épaisseur Z1, Z2, ...Z5 de même structure et de même composition, chaque couche correspondant à la zone de germination et de croissance compétitive typique des dépôts de structures colonnaires réalisés en phase vapeur.

La morphologie du revêtement est plutôt fibreuse que colonnaire, les fibres étant sensiblement perpendiculaires au plan du revêtement. Le diamètre des fibres n'excède pas 5 micromètres.

L'épaisseur de chaque couche est inférieure à 150 micromètres et préférentiellement comprise entre 1 et 10 micromètres. Les épaisseurs des couches successives peuvent être différentes les unes des autres.

Le concept de couche céramique à germination répétée est différent du concept de microcomposites stratifiés en ce sens que

- les couches adjacentes les unes aux autres sont les mêmes du point de vue de la composition et de la microstructure. L'épaisseur des couches peut cependant varier.

De plus, pour ce qui est d'une application aux revêtements à vocation de barrière thermique, le concept de couche céramique à germination répétée est différent du concept de microcomposites stratifiés dans la mesure où:

- s'il y a formation d'une interface entre deux couches adjacentes, cette interface n'a pas vocation à réduire le flux thermique mais à contrôler la structure de la couche que l'on cherche à répéter.

- c'est la structure de chaque couche regerminée qui contribue à diminuer la conductivité thermique de la couche et non pas les interfaces entre chaque couche.

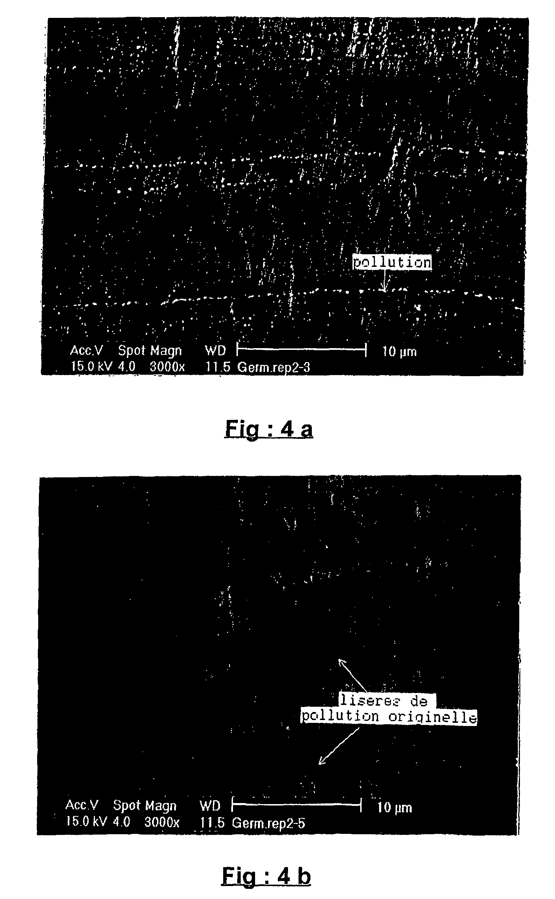

La céramique obtenue et représentée sur les figures 4a et 4b présente une structure fine de morphologie fibreuse plutôt que colonnaire qui confère à un tel dépôt une densité surfacique et une énergie de surface associée élevée ce qui le rend particulièrement sensible aux phénomènes de frittage aux hautes températures. En d'autres termes, le vieillissement thermique en fonctionnement peut occasionner une évolution importante de la morphologie du revêtement due aux phénomènes de frittage. Les interfaces entre chaque zone de céramique regerminée sont amenées à disparaître. Les fibres se soudent les unes aux autres pour former une fine dispersion de porosités plus ou moins sphériques qui est très efficace pour réduire la conductivité thermique de la couche. Cette évolution ne mène pas à l'augmentation de la conductivité thermique de la couche mais plutôt à sa diminution.

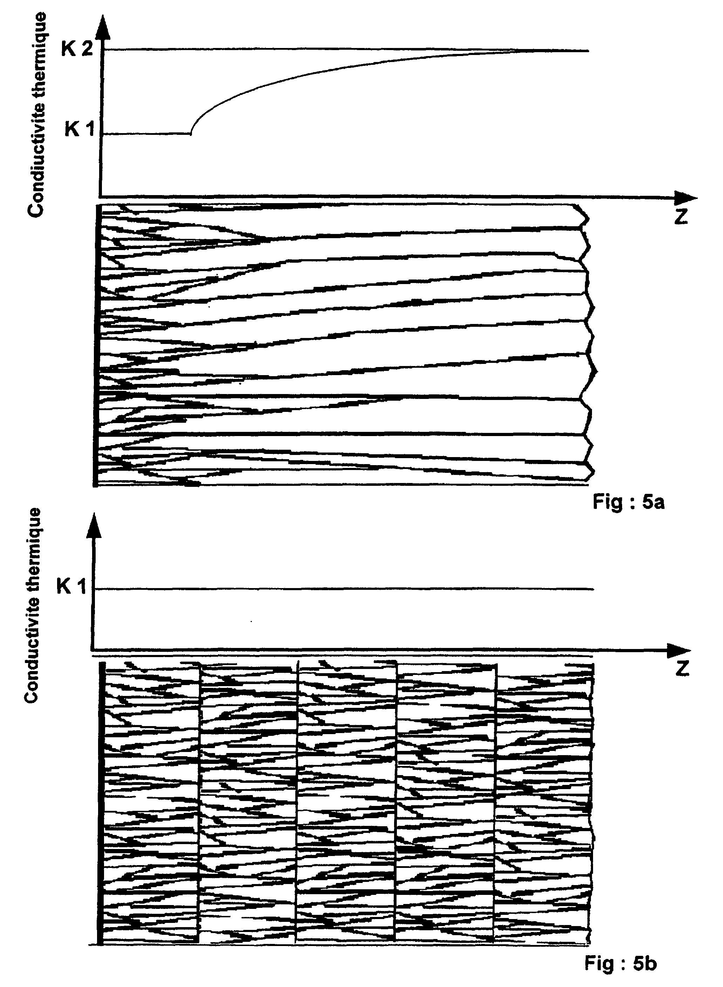

Les figures 5a et 5b montrent schématiquement l'évolution de la conductivité thermique d'un revêtement céramique classique (figure 5a), respectivement à germination répétée (figure 5b), en fonction de l'épaisseur du revêtement.

La conductivité thermique d'un revêtement céramique à germination répétée n'augmente plus avec l'épaisseur du revêtement et sa valeur est voisine de la valeur obtenue pour un revêtement céramique classique de faible épaisseur.

L'invention concerne également une pièce métallique ayant au moins une partie de sa surface revêtue par un tel revêtement céramique.

Cette pièce métallique peut être en superalliage. Préalablement à l'application de cette couche céramique, on peut revêtir la surface de la pièce avec une sous-couche métallique en alliage aluminoformeur. Cette sous-couche de liaison peut appartenir à la classe des MCrAlY ou aux dépôts diffusés qui consistent en des aluminiures constitués en partie de nickel et de métaux précieux tels que les éléments de la mine du platine. Préférentiellement, le taux de soufre dans l'alliage de base et dans la sous-couche est inférieur à 0,8ppm en poids. L'application de la couche céramique peut être précédée de la formation d'un film d'alumine adhérent à la surface de la sous-couche ou à la surface du superalliage sans sous-couche.

La regermination de la couche céramique n'est pas un processus immédiat à réaliser. Des essais de dépôt intermittent avec le procédé EB-PVD par l'utilisation d'un obturateur de la source d'évaporation ont montré qu'il ne suffit pas d'interrompre le dépôt, puis de le reprendre, pour obtenir la regermination de la couche céramique. De même que le régime de dépôt intermittent sur la surface d'une pièce, du fait de sa mise en rotation dans le flux de vapeur de céramique typique du procédé industriel EB-PVD, ne mène pas à la regermination de la couche céramique. Cependant, nous avons observé que la regermination de la couche céramique peut être obtenue quand le dépôt de céramique est repris à la surface d'une couche céramique formée préalablement dans une fournée de dépôt antérieure. Nous interprétons ce résultat par le fait qu'une fois que le vide est cassé et que la pièce recouverte est sortie de l'enceinte EB-PVD, la surface du dépôt céramique est effectivement polluée. Les molécules de céramique qui se condensent à la surface d'une couche de céramique préalablement polluée ne reconnaissent plus les plans cristallographiques de cette céramique et ne peuvent donc pas établir une relation d'épitaxie avec cette surface. La reprise d'un dépôt sur une surface polluée mène donc à la regermination de la couche céramique. Cependant, un procédé de réalisation de barrière thermique qui consisterait à déposer des fines couches élémentaires en plusieurs fournées de dépôt dans le but de les faire regerminer les unes sur les autres constitue une solution difficilement applicable industriellement.

L'invention concerne donc également un procédé de dépôt en phase vapeur industriellement viable pour former des couches de céramique à germination répétée. Le procédé consiste à provoquer plusieurs fois la regermination in situ de la couche céramique EB-PVD sans interrompre le dépôt. Pour cela, on exploite le fait que la surface du revêtement sur laquelle se condense les molécules de céramique est particulièrement réactive en cours de dépôt du fait des liaisons libres des atomes en surface et de la déficience en oxygène. La méthode utilisée de regermination de la couche céramique sans interrompre le dépôt consiste à polluer in situ la surface du revêtement en cours de dépôt. La pollution de la surface peut être réalisée par différentes méthodes.

Une première méthode de pollution, appelée méthode de pollution chimique in situ, consiste à faire réagir la surface des pièces avec un gaz polluant réactif à l'intérieur de l'enceinte. Le gaz polluant est introduit de façon intermittente dans l'enceinte de dépôt et interagit avec la surface de la couche céramique en cours de dépôt et/ou avec les espèces chimiques présentes en phase vapeur dans le volume de l'enceinte de dépôt de façon à provoquer la regermination du matériau céramique en cours de condensation. L'introduction fugitive d'un gaz réactif conduit à la formation partielle d'un composé autre que la zircone à la surface du revêtement en cours de dépôt. La formation d'un composé superficiel revient effectivement à polluer in situ la surface de la couche céramique en cours de dépôt et à provoquer sa regermination sans interrompre le dépôt. Le composé superficiel peut-être discontinu. Sa distribution à la surface de la céramique suffit à provoquer la regermination de la couche céramique. Parmi les gaz réactifs envisagés dans le cas où la céramique est composée d'oxydes, on préfère des gaz qui mènent à la nitruration ou à la carburation partielle et superficielle de la couche de céramique. Dans le cas où le revêtement céramique est constitué de carbures, on préfère des gaz réactifs qui mènent à la nitruration ou à l'oxydation partielle et superficielle de la couche de céramique. Dans le cas où le revêtement céramique est constitué de nitrures, on préfère des gaz réactifs qui mènent à la carburation ou à l'oxydation partielle et superficielle de la couche de céramique. Typiquement, le gaz polluant est atomique ou moléculaire et est constitué partiellement d'atomes choisis parmi les éléments C, N, O, H, Si, cl, Br, F, I. Le gaz polluant peut être de l'air. Dans le cas général, des gaz réactifs contenant de l'azote, de l'ammoniac, des hydrocarbures, des oxydes de carbone, de l'hydrogène ou encore des gaz halogénés peuvent être utilisés.

Une deuxième méthode de pollution appelée méthode de pollution physique in situ, consiste à faire interagir la surface des pièces en cours de dépôt avec un gaz non-réactif qui peut s'adsorber à la surface du dépôt sans donner lieu à une réaction chimique. L'adsorption de molécules de gaz à la surface du dépôt perturbe la condensation de molécules de céramiques sur des plans cristallographiques bien définis. L'introduction fugitive d'un gaz non réactif mais possédant un pouvoir d'adsorption fort avec la surface de la couche céramique en cours de dépôt peut rompre la relation d'épitaxie ce qui mène effectivement à la regermination de la couche céramique. Les gaz non réactifs que l'on peut envisager pour produire une pollution physique in situ, peuvent être choisis parmi les gaz neutres et tout autre gaz non réactif qui possède un pouvoir d'adsorption fort avec la surface du matériau céramique déposé, tel que par exemple des gaz rares Xe, Kr, Ar, He, des mélanges de gaz rares, l'oxyde de carbone.

Une troisième méthode d'élaboration d'une couche céramique à germination répétée consiste à faire condenser de façon intermittente un matériau différent de celui utilisé pour constituer la couche de céramique, en conjonction avec la condensation ininterrompue de vapeur céramique. La condensation fugitive d'un matériau autre que celui de la couche céramique en cours de dépôt constitue la pollution. Cela peut être réalisé par l'émission d'un flash de vapeur du matériau dit polluant en concomitance avec l'évaporation ininterrompue du matériau céramique. Le matériau polluant peut être un métal ou un matériau céramique de composition différente de celle de la couche céramique déposée. Industriellement ce procédé peut être réalisé en ayant recours à deux creusets d'évaporation contenant respectivement le matériau céramique et le matériau polluant, les deux matériaux étant évaporés individuellement par un faisceau d'électrons. Le matériau céramique placé dans le premier creuset est évaporé en continu alors que le matériau polluant placé dans le deuxième creuset est évaporé de façon intermittente par un faisceau d'électron séparé.

Une quatrième méthode d'élaboration d'une couche céramique à germination répétée consiste à exploiter la réactivité de la vapeur de céramique dans la zone d'évaporation. Du fait de l'excitation thermique et de l'interaction avec les électrons primaires et secondaires provenant du bombardement électronique, les molécules de céramique peuvent se trouver dissociées, excitées et/ou ionisés. Ces différents états d'excitation des espèces en phase vapeur favorise leur interaction chimique avec un gaz réactif. La condensation du produit de la réaction chimique entre un gaz polluant et la vapeur de céramique à la surface du revêtement en cours de dépôt, constitue la pollution.

Pour accroître l'efficacité de cette méthode, le gaz polluant peut être introduit localement à proximité de la zone de l'évaporation.

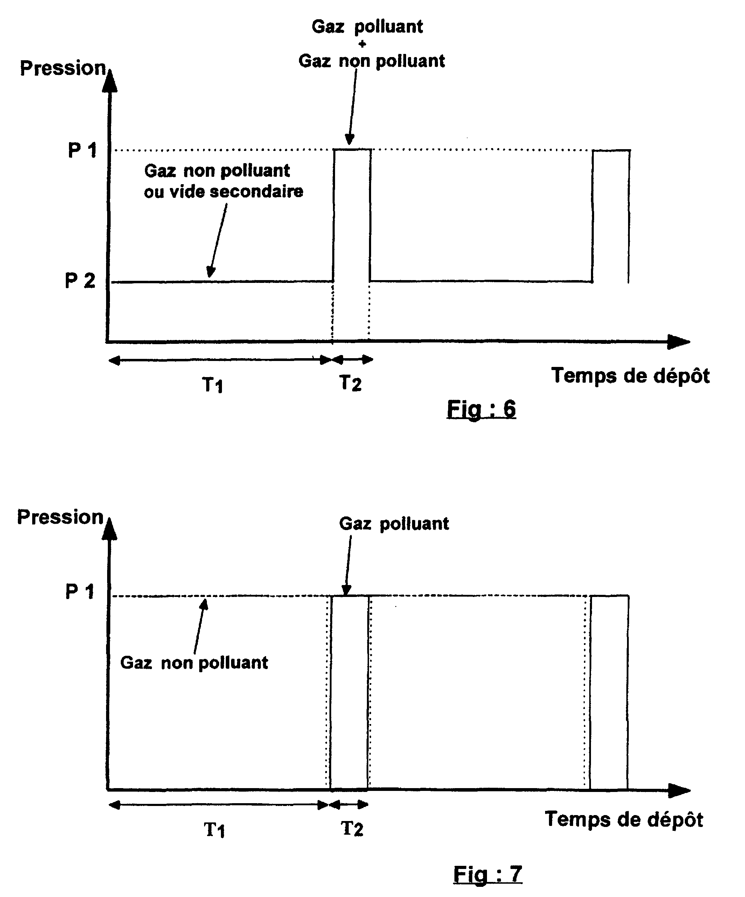

Un premier exemple de cycle d'introduction du gaz polluant est montré sur la figure 6.

La pièce est introduite dans l'enceinte de dépôt à haute température en présence d'une pression partielle d'oxygène. L'oxygène présent dans les phases initiales du dépôt sert à promouvoir la formation d'un film d'alumine sur lequel va se condenser la vapeur de céramique. Une certaine pression partielle d'oxygène est assurée dans l'enceinte EB-PVD du fait de la dissociation de l'oxyde réfractaire pendant l'évaporation. Accessoirement, l'enceinte de dépôt peut être alimentée avec un gaz riche en oxygène pendant la phase d'introduction des pièces dans la chambre de préchauffage et pendant la phase initiale du dépôt. Ce gaz est non polluant. Après un certain temps de dépôt $T_1$ à pression et débit de gaz non polluant constants, un gaz polluant est introduit dans l'enceinte pendant un temps $T_2$ court devant le temps $T_1$. L'introduction du gaz polluant peut se faire à débit de gaz non polluant constant. Préférentiellement, l'introduction du gaz polluant est abrupte (signal carré). Pour cela une régulation en pression est imposée sur le débit du gaz polluant avec comme consigne une valeur de pression haute $P_1$ (voir Figure 5). Après un temps $T_2$, le débit de gaz polluant est coupé et la vitesse de pompage de la chambre est régulée avec comme consigne une valeur de pression basse $P_2$. La vitesse de pompage est contrôlée par exemple par l'ouverture d'un diaphragme disposé à l'entrée des pompes.

D'une façon alternative, représentée sur la figure 7, l'introduction de gaz polluant peut se faire à pression totale dans la chambre constante en diminuant le débit de gaz non polluant. Quelle que soit la configuration choisie, la pression partielle du gaz polluant doit être suffisante pour réagir avec la surface de la couche céramique en cours de dépôt afin de provoquer la regermination. Ce seuil de pression partielle de gaz polluant utilisé dépend de la nature du gaz utilisé. Le gaz polluant choisi dépend de sa réactivité chimique ou physique avec le matériau céramique qui constitue la couche de barrière thermique que l'on cherche à déposer. Les temps $T_1$ et $T_2$ sont choisis en fonction de la vitesse de dépôt de la céramique. Typiquement, l'épaisseur de céramique déposée au terme de la période $T=T_1 + T_2$ n'excède pas 50 micromètres. Préférentiellement, l'épaisseur de céramique déposée au terme de la période $T=T_1 + T_2$ n'excède pas 20 micromètres.

Le procédé de dépôt en phase vapeur peut être un procédé chimique CVD ou physique PVD. Préférentiellement, la vaporisation peut être accomplie par chauffage sous faisceau d'électrons.

Dans le cas où la couche céramique est composée d'un oxyde ou d'un mélange d'oxydes, les composés qui sont le produit de la réaction entre la céramique et le gaz polluant (oxynitrures, carbures, carbonitrures, ...) tendent à disparaître pendant le fonctionnement dû à l'oxydation aux hautes températures. Ce n'est pas gênant dans la mesure où leur présence a pour but unique de causer la regermination de la couche céramique. Leur stabilité thermique post déposition n'est pas nécessaire. Dans le cas où la regermination de la couche céramique est le produit de l'introduction intermittente d'un gaz non réactif fortement adsorbant à la surface de la couche céramique en cours de dépôt, les gaz ainsi piégés tendent à se résorber après un recuit à des températures supérieures à celle du dépôt. Ce n'est pas gênant dans la mesure où leur présence a pour but unique de causer la regermination de la couche céramique.

Enfin, l'invention présente l'intérêt d'être facile à mettre en oeuvre avec les installations de dépôt en phase vapeur industrielles courantes.

**Revendications**

1.   Revêtement céramique de type barrière thermique déposé sur un substrat **caractérisé en ce qu'**il comporte en épaisseur, un motif de croissance colonnaire interrompu et répété plusieurs fois par regermination successive du dépôt de céramique de manière à obtenir des couches adjacentes de même composition et de même structure.

2.   Revêtement céramique selon la revendication 1, **caractérisé en ce qu'**il comporte des interfaces parallèles au substrat, les interfaces séparant des couches de céramique ayant une même structure et une même composition, chaque couche de céramique correspondant à une zone de germination et de croissance compétitive.

3. Revêtement céramique selon la revendication 2, **caractérisé en ce que** chaque couche de céramique a une structure fibreuse, chaque fibre étant sensiblement perpendiculaire au substrat.

4. Revêtement céramique selon la revendication 3, **caractérisé en ce que** les fibres ont un diamètre maximum inférieur ou égal à 5 micromètres.

5. Revêtement céramique selon la revendication 2, **caractérisé en ce que** chaque couche a une épaisseur inférieure ou égale à 150 micromètres.

6. Revêtement céramique selon la revendication 5, **caractérisé en ce que** chaque couche a une épaisseur comprise entre 1 et 20 micromètres.

7. Procédé de dépôt en phase vapeur d'un revêtement céramique de type barrière thermique dans lequel une germination et une croissance du revêtement sont réalisées dans une enceinte de dépôt par condensation de vapeur sur un substrat à recouvrir, **caractérisé en ce qu'**il consiste à introduire dans l'enceinte de dépôt, pendant le dépôt et de façon intermittente, un gaz polluant interagissant avec la surface de la céramique en cours de dépôt et/ou avec des espèces chimiques présentes en phase vapeur dans l'enceinte de dépôt, de façon à provoquer des regerminations successives de la céramique en cours de condensation.

8. Procédé de dépôt selon la revendication 7, **caractérisé en ce que** le gaz polluant interagit chimiquement avec la surface de la céramique en cours de dépôt.

9. Procédé de dépôt selon la revendication 8, **caractérisé en ce que** le gaz polluant est atomique ou moléculaire et comporte au moins des atomes choisis parmi les éléments C, N, O, H, Si, Cl, Br, F, I.

10. Procédé de dépôt selon la revendication 9, **caractérisé en ce que** le gaz polluant est de l'air.

11. Procédé de dépôt selon la revendication 7, **caractérisé en ce que** le gaz polluant interagit physiquement par un processus d'adsorption avec la surface de la céramique en cours de dépôt.

12. Procédé de dépôt selon la revendication 11, **caractérisé en ce que** le gaz polluant est choisi parmi des gaz rares Xe, Kr, Ar, He, des mélanges de gaz rares, l'oxyde de carbone.

13. Procédé de dépôt en phase vapeur d'un revêtement céramique de type barrière thermique dans lequel une germination et une croissance du revêtement sont réalisés dans une enceinte de dépôt par condensation de vapeur sur un substrat à recouvrir, **caractérisé en ce qu'**il consiste à placer dans l'enceinte de dépôt deux creusets d'évaporation contenant respectivement le matériau céramique et un matériau polluant, à évaporer le matériau céramique en continu et à évaporer de façon intermittente le matériau polluant de façon à provoquer des regerminations successives de la céramique en cours de condensation.

14. Pièce métallique **caractérisé en ce qu'**elle comporte une surface revêtue au moins en partie par un revêtement céramique selon l'une quelconque des revendications 1 à 6.

15. Pièce métallique selon la revendication 14, **caractérisée en ce qu'**elle comporte en outre une sous-couche en alliage aluminoformeur sur laquelle est déposé le revêtement céramique.

**Patentansprüche**

1. Wärmedämmungs-Keramikbeschichtung, die auf einem Substrat aufgebracht ist,
   **dadurch gekennzeichnet,**
   **dass** sie in ihrer Stärke ein unterbrochenes und mehrfach wiederholtes Säulenwachstumsmuster durch wiederholte, aufeinanderfolgende Keimbildung der Keramikbeschichtung dergestalt aufweist, dass aneinandergrenzende Schichten gleicher Zusammensetzung und gleicher Struktur entstehen.

2. Keramikbeschichtung nach Anspruch 1,
   **dadurch gekennzeichnet,**
   **dass** sie Grenzflächen aufweist, die parallel zu dem Substrat verlaufen, wobei die Grenzflächen Keramikschichten mit einer gleichen Struktur und einer gleichen Zusammensetzung voneinander trennen, wobei jede Keramikschicht einem Bereich der wiederholten Keimbildung und des konkurrierenden Wachsens entspricht.

3. Keramikbeschichtung nach Anspruch 2,
   **dadurch gekennzeichnet,**
   **dass** jede Keramikschicht eine faserhaltige Struktur hat, wobei jede Faser im wesentlichen senkrecht zum Substrat verläuft.

4. Keramikbeschichtung nach Anspruch 3,
   **dadurch gekennzeichnet,**
   **dass** die Fasern einen maximalen Durchmesser von kleiner oder gleich 5 Mikrometer haben.

**5.** Keramikbeschichtung nach Anspruch 2,
    **dadurch gekennzeichnet,**
    **dass** jede Schicht eine Stärke von kleiner oder gleich 150 Mikrometer hat.

**6.** Keramikbeschichtung nach Anspruch 5,
    **dadurch gekennzeichnet,**
    **dass** jede Schicht eine Stärke von 1 bis 20 Mikrometer hat.

**7.** Verfahren zur Herstellung einer Wärmedämmungs-Keramikbeschichtung in der Dampfphase, bei dem in einem Beschichtungsraum durch Dampfniederschlag auf einem zu beschichtenden Substrat eine Keimbildung und ein Wachstum der Beschichtung erfolgen,
    **dadurch gekennzeichnet,**
    **dass** es darin besteht, während des Beschichtens auf intermittierende Weise ein verschmutzendes Gas in den Beschichtungsraum einzuführen, das mit der Oberfläche der sich gerade niederschlagenden Keramik und/oder mit den in der Dampfphase in dem Beschichtungsraum vorhandenen chemischen Arten dergestalt interagiert, dass aufeinanderfolgende, sich wiederholende Keimbildungen der sich gerade niederschlagenden Keramik bewirkt werden.

**8.** Beschichtungsverfahren nach Anspruch 7,
    **dadurch gekennzeichnet,**
    **dass** das verschmutzende Gas chemisch mit der Oberfläche der sich gerade niederschlagenden Keramik interagiert.

**9.** Beschichtungsverfahren nach Anspruch 8,
    **dadurch gekennzeichnet,**
    **dass** das verschmutzende Gas atomar oder molekular ist und mindestens Atomen aufweist, die aus den Elementen C, N, O, H, Si, Cl, Br, F, I gewählt sind.

**10.** Beschichtungsverfahren nach Anspruch 9,
    **dadurch gekennzeichnet,**
    **dass** das verschmutzende Gas Luft ist.

**11.** Beschichtungsverfahren nach Anspruch 7,
    **dadurch gekennzeichnet,**
    **dass** das verschmutzende Gas durch einen Adsorptionsprozess physikalisch mit der Oberfläche der sich gerade niederschlagenden Keramik interagiert.

**12.** Beschichtungsverfahren nach Anspruch 11,
    **dadurch gekennzeichnet,**
    **dass** das verschmutzende Gas aus den seltenen Gasen Xe, Kr, Ar, He, Gemischen seltener Gase, Kohlenmonoxid gewählt wird.

**13.** Verfahren zur Herstellung einer Wärmedämmungs-Keramikbeschichtung in der Dampfphase, bei dem in einem Beschichtungsraum durch Dampfniederschlag auf einem zu beschichtenden Substrat eine Keimbildung und ein Wachstum der Beschichtung erfolgen,
    **dadurch gekennzeichnet,**
    **dass** es darin besteht, in den Beschichtungsraum zwei Bedampfungsschiffchen einzuführen, die das Keramikmaterial bzw. ein Verschmutzungsmaterial enthalten, wobei das Keramikmaterial kontinuierlich verdampft wird und das Verschmutzungsmaterial intermittierend verdampft wird so dass aufeinanderfolgende, sich wiederholende Keimbildungen der sich gerade niederschlagenden Keramik bewirkt werden.

**14.** Metallteil,
    **dadurch gekennzeichnet,**
    **dass** es eine Oberfläche hat, die wenigstens zum Teil mit einer Keramikbeschichtung nach einem der Ansprüche 1 bis 6 überzogen ist.

**15.** Metallteil nach Anspruch 14,
    **dadurch gekennzeichnet,**
    **dass** es ferner eine Unterschicht aus einer aluminiumbildenden Legierung aufweist, auf der die Keramikbeschichtung aufgebracht ist.

**Claims**

**1.** A ceramic heat barrier coating deposited on a substrate, **characterised in that** it comprises in thickness a columnar growth pattern which is interrupted and repeated a number of times by successive regermination of a ceramic deposit so as to obtain adjacent layers of identical composition and structure.

**2.** A ceramic coating according to claim 1, **characterised in that** it comprises interfaces parallel to the substrate, the interfaces separating the ceramic layers of identical structure and composition, each ceramic layer corresponding to a zone of germination and competitive growth.

**3.** A ceramic coating according to claim 2, **characterised in that** each ceramic layer has a fibrous structure, each fibre being substantially perpendicular to the substrate.

**4.** A ceramic coating according to claim 3, **characterised in that** the fibres have a maximum diameter less than or equal to 5μm.

**5.** A ceramic coating according to claim 2, **characterised in that** each layer has a thickness less than or

equal to 150μm.

**6.** A ceramic coating according to claim 5, **characterised in that** each layer has a thickness between 1 and 20 μm.

**7.** A process for vapour phase deposition of a ceramic heat barrier coating wherein the coating is germinated and grown in a deposition chamber by vapour condensation on a substrate to be covered, **characterised in that** it comprises intermittently introducing into the deposition chamber, during deposition, a polluting gas which interacts with the surface of the ceramic which is being deposited and/or with chemical components present in vapour phase in the deposition chamber so as to produce successive regerminations of the ceramic which is being condensed.

**8.** A deposition process according to claim 7, **characterised in that** the polluting gas interacts chemically with the surface of the ceramic which is being deposited.

**9.** A deposition process according to claim 8, **characterized in that** the polluting gas is atomic or molecular and comprises at least atoms chosen from among the elements C, N, O, H, Si, Cl, Br, F and I.

**10.** A deposition process according to claim 9, **characterised in that** the polluting gas is air.

**11.** A deposition process according to claim 7, **characterised in that** the polluting gas interacts physically by adsorption on the surface of the ceramic which is being deposited.

**12.** A deposition process according to claim 11, **characterized in that** the polluting gas is chosen from among rare gases Xe, Kr, Ar, He, mixtures of rare gases and carbon monoxide.

**13.** A process for vapour phase deposition of a ceramic heat barrier coating wherein the coating is germinated and grown in a deposition chamber by vapour condensation on a substrate to be covered, **characterised in that** it consists of placing two crucibles containing ceramic material and a contaminating material respectively in the deposition chamber, evaporating the ceramic material continuously, and evaporating the polluting material intermittently, so as to produce successive regerminations of the ceramic which is being condensed.

**14.** A metal article, **characterised in that** it comprises a surface coated at least partly by a ceramic coating according to any of claims 1 to 6.

**15.** A metal article according to claim 14, **characterised in that** it also comprises a sub-layer of alumino-forming alloy on which the ceramic coating is deposited.

Fig : 2

Fig : 1

**Fig : 3**

Acc.V  Spot Magn    WD ┣━━━━━━━━━━━┫  10 µm
15.0 kV 4.0  3000x   11.5 Germ.rep2-3

**Fig : 4 a**

Acc.V  Spot Magn    WD ┣━━━━━━━━━━━┫  10 µm
15.0 kV 4.0  3000x   11.5 Germ.rep2-5

**Fig : 4 b**

13

Fig : 5a

Fig : 5b

Fig : 6

Fig : 7